# EUROPEAN PATENT APPLICATION

(11) **EP 1 394 941 A2**
(43) Date of publication of application: **03.03.2004**
(21) Application number: 03292135.5
(22) Date of filing: 29.08.2003
(51) Int. Cl.: H03H 9/64

(54) **Surface acoustic-wave apparatus and communications apparatus**

(30) Priority: 29.08.2002 JP 2002251950
(71) Applicant: Murata Manufacturing Co., Ltd., Nagaokakyo-shi Kyoto-fu 617-8555 (JP)
(72) Inventor: Takamine, Yuichi, Murata Manufacturing Co., Ltd., Nagaokakyo-shi Kyoto-fu 617-8555 (JP); Shibahara, T., Murata Manufacturing Co., Ltd., Nagaokakyo-shi Kyoto-fu 617-8555 (JP)
(74) Representative: Joly, Jean-Jacques

(57) **Abstract**

A longitudinally-coupled-resonator-type surface-acoustic-wave filter (101) in which three interdigital transducers (102-4) are formed on a piezoelectric substrate (501) in the direction in which surface acoustic waves propagate is provided. An interdigital transducer (103) disposed at the center among the three interdigital transducers of the longitudinally-coupled-resonator-type surface-acoustic-wave filter is divided into two parts (110,111) substantially symmetrically in the propagation direction of the surface acoustic waves and the two parts (110,111) are connected to balanced signal terminals (108,109), respectively. Left and right interdigital transducers (102,104) of which the polarities are inverted to each other are connected to an unbalanced signal terminal (107) to provide a balanced-to-unbalanced conversion function. A reactance component (120) formed, on the piezoelectric substrate (501), inside a package, or outside the package is connected to either of the balanced signal terminals (108).

## Description

### BACKGROUND OF THE INVENTION

### 1. Field of the Invention

The present invention relates to surface-acoustic-wave apparatuses provided with a surface-acoustic-wave filter having a balanced-to-unbalanced conversion function.

### 2. Description of the Related Art

Remarkable technical progress has been made on portable telephones (communications apparatuses) these days in terms of their compactness and light weight. As means to implement it, the number of components has been reduced, components have been made compact, and components having a plurality of functions have been developed.

With a background of such conditions, surface-acoustic-wave apparatuses having a balanced-to-unbalanced conversion function, a so-called balun function, used in RF stages of portable telephones have been actively researched, and have been used mainly in global systems for mobile communications (GSMs).

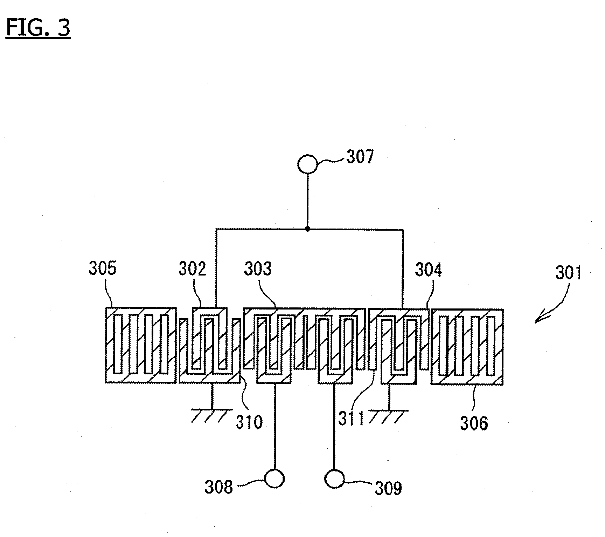

Several patent applications related to surface-acoustic-wave apparatuses having a balanced-to-unbalanced conversion function have been filed. Fig. 3 shows the surface-acoustic-wave apparatus having a balanced-to-unbalanced conversion function with the impedance of an unbalanced signal terminal side being set to 50 Ω and the impedance of a balanced signal terminal side being set to 200 Ω and disclosed in Japanese Unexamined Patent Publication No. JP11-97966.

In the structure of Fig. 3, in a longitudinally-coupled-resonator-type surface-acoustic-wave filter 301 in which three interdigital transducers (hereinafter called IDTs) are formed in directions in which surface acoustic waves propagate, an IDT 303 disposed at the center is divided into two parts substantially symmetrically in the propagation directions of the surface acoustic waves, and the two parts are connected to balanced signal terminals 308 and 309, respectively, and left and right IDTs 302 and 304 having inverted polarities are connected to an unbalanced signal terminal 307. With this structure, a balanced-to-unbalanced conversion function is provided by the inverted polarities, and the impedance at the balanced signal terminal side is made about four times as high as that of the unbalanced signal terminal side by the division of the IDT 303 into the two parts.

It is required for filters having a balanced-to-unbalanced conversion function to have equal amplitude characteristics and phases inverted by 180 degrees in the transfer characteristics at a pass band between an unbalanced signal terminal and balanced signal terminals. They are called an amplitude-balance degree and a phase-balance degree.

The amplitude-balance degree and the phase-balance degree are defined in the following way assuming that filter apparatuses having a balanced-to-unbalanced conversion function are three-port devices. The amplitude-balance degree = |A|, A = |20log(S21)| - |201og(S31)|, the phase-balance degree = |B - 180|, B = |∠LS21 - ∠S31|, where an unbalanced input terminal is called port 1, and balanced output terminals are called port 2 and port 3. Ideally, the amplitude-balance degree should be 0 dB and the phase balance degree should be 0 degrees in the pass band of surface-acoustic-wave filters.

However, the conventional structure shown in Fig. 3 has bad balance degrees. It is because the electrode fingers (310 and 311 in Fig. 3) of the IDT 302 and the IDT 304, adjacent to the IDT 303 have different polarities from each other, and therefore, parasitic capacitances and bridging capacitances differ at the balanced signal terminals 308 and 309.

### SUMMARY OF THE INVENTION

An object of the present invention is to solve the above-described problem in the structure shown in Fig. 3, and to provide a surface-acoustic-wave apparatus which has a balanced-to-unbalanced conversion function with improved balance degrees and in which the impedance of balanced signal terminals are about four times as high as that of an unbalanced signal terminal.

The foregoing object is achieved in one aspect of the present invention through the provision of a surface-acoustic-wave apparatus including a longitudinally-coupled-resonator-type surface-acoustic-wave filter in which an odd number of three or more of interdigital transducers are formed on a piezoelectric substrate in the direction in which surface acoustic waves propagate, one interdigital electrode of an interdigital transducer disposed at the center among the odd number of interdigital transducers is divided into two parts along the propagation direction of the surface acoustic waves and the two parts are connected to balanced signal terminals, respectively, and two interdigital transducers adjacent to the interdigital transducer disposed at the center have structures inverted to each other and are connected to an unbalanced signal terminal to have a balanced-to-unbalanced conversion function, wherein an outermost electrode finger of the interdigital transducer disposed at the center is a floating electrode or a grounded electrode, and wiring is formed asymmetrically such that a balanced signal terminal closer to an interdigital transducer of which an outermost electrode finger adjacent to the interdigital transducer disposed at the center is grounded, of the two interdigital transducers adjacent to the interdigital transducer disposed at the center, has a relatively larger capacitance.

According to the above-described structure, since the wiring is formed asymmetrically such that a balanced signal terminal closer to an interdigital transducer of which an outermost electrode finger adjacent to the interdigital transducer disposed at the center is grounded, of the two interdigital transducers adjacent to the interdigital transducer disposed at the center has a relatively larger capacitance, balance degrees between the balanced signal terminals, especially the phase balance degree, is improved.

The foregoing object is achieved in another aspect of the present invention through the provision of a surface-acoustic-wave apparatus including a longitudinally-coupled-resonator-type surface-acoustic-wave filter in which an odd number of three or more of interdigital transducers are formed on a piezoelectric substrate in the direction in which surface acoustic waves propagate, one interdigital electrode of an interdigital transducer disposed at the center among the odd number of interdigital transducers is divided into two parts in the propagation direction of the surface acoustic waves and the two parts are connected to balanced signal terminals, respectively, and two interdigital transducers adjacent to the interdigital transducer disposed at the center have structures inverted to each other and are connected to an unbalanced signal terminal to have a balanced-to-unbalanced conversion function, wherein an outermost electrode finger of the interdigital transducer disposed at the center is a signal electrode, and wiring is formed asymmetrically such that a balanced signal terminal closer to an interdigital transducer of which an outermost electrode finger adjacent to the interdigital transducer disposed at the center is a signal electrode, of the two interdigital transducers adjacent to the interdigital transducer disposed at the center, has a relatively larger capacitance.

According to the above-described structure, since the wiring is formed asymmetrically such that a balanced signal terminal closer to an interdigital transducer of which an outermost electrode finger adjacent to the interdigital transducer disposed at the center is a signal electrode, of the two interdigital transducers adjacent to the interdigital transducer disposed at the center, has a relatively larger capacitance, balance degrees between the balanced signal terminals, especially the phase balance degree, is improved.

The above-described surface-acoustic-wave apparatus may be configured such that the piezoelectric substrate is mounted on a package by flip-chip bonding, and the asymmetrical wiring is formed on the package.

In the above-described surface-acoustic-wave apparatus, wiring on the piezoelectric substrate and on the package may be formed substantially symmetrically with respect to a virtual axis perpendicular to the propagation directions of the surface acoustic waves at the center of the interdigital transducer disposed at the center, except the asymmetrical wiring.

The foregoing object is achieved in still another aspect of the present invention through the provision of a surface-acoustic-wave apparatus including a longitudinally-coupled-resonator-type surface-acoustic-wave filter in which an odd number of three or more of interdigital transducers are formed on a piezoelectric substrate in the direction in which surface acoustic waves propagate, one interdigital electrode of an interdigital transducer disposed at the center among the odd number of interdigital transducers is divided into two parts in the propagation direction of the surface acoustic waves and the two parts are connected to balanced signal terminals, respectively, and two interdigital transducers adjacent to the interdigital transducer disposed at the center have structures inverted to each other and are connected to an unbalanced signal terminal to have a balanced-to-unbalanced conversion function, wherein an outermost electrode finger of the interdigital transducer disposed at the center is a floating electrode or a grounded electrode, and a reactance component or a delay line is added to a balanced signal terminal closer to an interdigital transducer of which an outermost electrode finger adjacent to the interdigital transducer disposed at the center is grounded, of the two interdigital transducers adjacent to the interdigital transducer disposed at the center.

According to the above-described structure, since the reactance component or the delay line is added to a balanced signal terminal closer to an interdigital transducer of which an outermost electrode finger adjacent to the interdigital transducer disposed at the center is grounded, balance degrees between the balanced signal terminals, especially the phase balance degree, is improved.

The foregoing object is achieved in yet another aspect of the present invention through the provision of a surface-acoustic-wave apparatus including a longitudinally-coupled-resonator-type surface-acoustic-wave filter in which an odd number of three or more of interdigital transducers are formed on a piezoelectric substrate in the direction in which surface acoustic waves propagate, one interdigital electrode of an interdigital transducer disposed at the center among the odd number of interdigital transducers is divided into two parts in the propagation direction of the surface acoustic waves and the two parts are connected to balanced signal terminals, respectively, and two interdigital transducers adjacent to the interdigital transducer disposed at the center have structures inverted to each other and are connected to an unbalanced signal terminal to have a balanced-to-unbalanced conversion function, wherein an outermost electrode finger of the interdigital transducer disposed at the center is a signal electrode, and a reactance component or a delay line is added to a balanced signal terminal closer to an interdigital transducer of which an outermost electrode finger adjacent to the interdigital transducer disposed at the center is a signal electrode, of the two interdigital transducers adjacent to the interdigital transducer disposed at the center.

According to the above-described structure, since an outermost electrode finger of the interdigital transducer disposed at the center is a signal electrode, and the reactance component or the delay line is added to a balanced signal terminal closer to the interdigital transducer of which an outermost electrode finger adjacent to the interdigital transducer disposed at the center is a signal electrode, of the two interdigital transducers adjacent to the interdigital transducer disposed at the center, balance degrees between the balanced signal terminals, especially the phase balance degree, is improved.

The above-described surface-acoustic-wave apparatus may be configured such that the piezoelectric substrate is mounted on a package by flip-chip bonding, and the reactance component or the delay line is formed on the package.

In the above-described surface-acoustic-wave apparatus, wiring on the piezoelectric substrate and on the package may be formed substantially symmetrically with respect to a virtual axis perpendicular to the propagation directions of the surface-acoustic waves at the center of the interdigital transducer disposed at the center, except for the reactance component or the delay line.

The above-described surface-acoustic-wave apparatuses may be configured such that the reactance component is a capacitance component, and is connected in parallel between the balanced signal terminal and a ground potential. The above-described surface-acoustic-wave apparatuses may be configured such that the reactance component is an inductance component, and is connected in series to the balanced signal terminal.

In the above-described surface-acoustic-wave apparatuses, a surface-acoustic-wave resonator may be added in series and/or in parallel to the surface-acoustic-wave filter. In the above-described surface-acoustic-wave apparatuses, a plurality of the surface-acoustic-wave filters may be connected in cascade to each other. In the above-described surface-acoustic-wave apparatus, it is preferred that the total number of the electrode fingers of the surface-acoustic-wave filters connected in cascade be an even number.

It is preferred in the above-described surface-acoustic-wave apparatus that interdigital transducers positioned at both ends of each of the surface-acoustic-wave filters connected in cascade to each other be connected to interdigital transducers positioned at both ends of another, by signal lines, and the phases of signals passing through the signal lines be different by about 180 degrees.

In the above-described surface-acoustic-wave apparatuses, an electrode finger of at least one interdigital transducer of adjacent interdigital transducers, close to the boundary of the interdigital transducers, may be weighted in the surface-acoustic-wave filter. In the above-described surface-acoustic-wave apparatus, the weighting may be performed by series weighting.

The above-described surface-acoustic-wave apparatuses may be configured such that the piezoelectric substrate is mounted on a package by flip-chip bonding, the package has six external terminals, one unbalanced signal terminal, two balanced signal terminals, and three ground terminals, and the six terminals are arranged substantially symmetrically against a virtual axis perpendicular to the propagation direction of the surface acoustic waves at the center of the interdigital transducer positioned at the center of the surface-acoustic-wave filter.

The above-described surface-acoustic-wave apparatuses may be configured such that the piezoelectric substrate is mounted on a package by flip-chip bonding, the package has five external terminals, one unbalanced signal terminal, two balanced signal terminals, and two ground terminals, and the five terminals are arranged substantially symmetrically with respect to a virtual axis perpendicular to the propagation directions of the surface acoustic waves at the center of the interdigital transducer positioned at the center of the surface-acoustic-wave filter.

The foregoing object is achieved in still yet another aspect of the present invention through the provision of a communications apparatus including the first-described surface-acoustic-wave apparatus. According to the structure, since the communications apparatus has the surface-acoustic-wave apparatus, which has superior balance degrees, the communications apparatus has improved communications characteristics.

As described above, a surface-acoustic-wave apparatus according to certain embodiments of the present invention is a longitudinally-coupled-resonator-type surface-acoustic-wave filter in which three IDTs are formed on a piezoelectric substrate in the directions in which surface acoustic waves propagate. In the surface-acoustic-wave apparatus, an IDT disposed at the center among the three IDTs is divided into two parts substantially symmetrically in the propagation directions of the surface acoustic waves, the two parts are connected to balanced signal terminals, respectively, and left and right IDTs of which the polarities are inverted to each other are connected to unbalanced signal terminals to provide a balanced-to-unbalanced conversion function. A reactance component is connected to either of the balanced signal terminals by at least one of the forms of being on the piezoelectric substrate, in the package, and through an external connection to the package.

Therefore, the above-described structure shows the advantage that the balance degrees between the balanced signal terminals are improved, when a reactance component is connected to either of the balanced signal terminals.

The above and other objects, features and advantages of the present invention will become apparent from the following description of preferred embodiments thereof, given by way of example, illustrated by the accompanying drawings, in which:

### BRIEF DESCRIPTION OF THE DRAWINGS

Fig. 1 is a structural view of a surface-acoustic-wave apparatus according to the present invention;
Fig. 2 is a structural view of a modification (cascade connection) of the surface-acoustic-wave apparatus;
Fig. 3 is a structural view of a conventional surface-acoustic-wave apparatus;
Fig. 4 is a structural view showing the electrode structure of a surface-acoustic-wave apparatus according to a first embodiment of the present invention;
Fig. 5 is a plan view showing a layout on a piezoelectric substrate of the surface-acoustic-wave apparatus according to the first embodiment;
Fig. 6 is a plan view showing the arrangement of terminals at the rear surface of a package in which the surface-acoustic-wave apparatus according to the first embodiment is accommodated, in a see-through view viewed from the upper-surface (the surface opposite the rear surface) side of the package;
Fig. 7 is a cross-sectional view of the package of Fig.6 in which the surface-acoustic-wave apparatus according to the first embodiment is accommodated;
Fig. 8 is a graph indicating the phase balance degrees of the first embodiment and a first comparative example;
Fig. 9 is a plan view showing a layout in a surface-acoustic-wave apparatus according to the first comparative example;
Fig. 10 is a plan view showing a layout in a surface-acoustic-wave apparatus serving as a second comparative example;
Fig. 11 is a graph indicating the phase balance degrees of the second comparative example shown in Fig. 10 and the first comparative example;
Fig. 12 is a structural view showing the electrode structure of a surface-acoustic-wave apparatus according to a modification of the first embodiment;
Fig. 13 is a graph showing the relationships between the frequency and phase balance degree, of the second comparative example and of a case in which the electrode structure shown in Fig. 12 is used at the layout on the piezoelectric substrate shown in Fig. 10;
Fig. 14 is a graph showing the relationships between the frequency and phase balance degree, of the second comparative example and of a case in which the electrode structure shown in Fig. 12 is used at the layout on the piezoelectric substrate shown in Fig. 5;
Fig. 15 is a structural view showing a surface-acoustic-wave apparatus according to another modification of the first embodiment;
Fig. 16 is a structural view showing a surface-acoustic-wave apparatus according to still another modification of the first embodiment;
Fig. 17 is a graph showing the relationships between the frequency and phase balance degree, of the structure shown in Fig. 15 and of the second comparative example;
Fig. 18 is a graph showing the relationships between the frequency and phase balance degree, of the structure shown in Fig. 16 and of the second comparative example;
Fig. 19 is a plan view showing a layout on a piezoelectric substrate of a surface-acoustic-wave apparatus according to still another modification of the first embodiment;
Fig. 20 is a plan view showing another arrangement of electrode terminals in the package of the first embodiment;
Fig. 21 is a plan view showing a layout on a piezoelectric substrate of still another modification of the surface-acoustic-wave apparatus according to the first embodiment;
Fig. 22 is a cross-sectional view illustrating a manufacturing process of the surface-acoustic-wave apparatus according to the first embodiment;
Fig. 23 is a cross-sectional view illustrating another manufacturing process of the surface-acoustic-wave apparatus according to the first embodiment;
Fig. 24 is a structural view showing still another modification of the surface-acoustic-wave apparatus according to the first embodiment;
Fig. 25 is a structural view showing still another modification of the surface-acoustic-wave apparatus according to the first embodiment;
Fig. 26 is a plan view showing an example layout on the piezoelectric substrate in a case in which the electrode structure shown in Fig. 2 is mounted to the package having the electrode terminals at the rear surface side, shown in Fig. 6;
Fig. 27 is a plan view showing another example layout on the piezoelectric substrate in a case in which the electrode structure shown in Fig. 2 is mounted to the package having the electrode terminals at the rear surface side, shown in Fig. 6;
Fig. 28 is a plan view showing an example layout on the piezoelectric substrate in a case in which the electrode structure shown in Fig. 2 is mounted to the package having the electrode terminals at the rear surface side, shown in Fig. 20;
Fig. 29 is a plan view showing another example layout on the piezoelectric substrate in a case in which the electrode structure shown in Fig. 2 is mounted to the package having the electrode terminals at the rear surface side, shown in Fig. 20;
Fig. 30 is a block diagram showing main sections of a communications apparatus according to the present invention; and
Fig. 31A and Fig. 31B show cross-sectional views of packages in which the surface-acoustic-wave apparatus according to the first embodiment is accommodated, and to which a reactance component or a delay line is externally connected. Fig. 31A is a view of a case in which a circuit serving as the reactance component or the delay line is formed between a bottom plate and a side wall section, and Fig. 31B is a view of a case in which the reactance component or the delay line is formed as a circuit in a multi-layer substrate in which a lamination plate is formed on the bottom plate.

### DESCRIPTION OF THE PREFERRED EMBODIMENTS

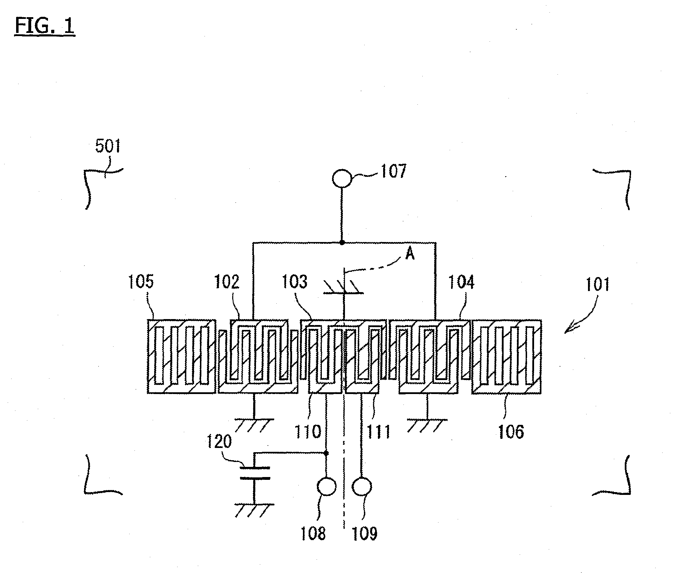

A surface-acoustic-wave apparatus according to a preferred embodiment of the present invention will be described below by referring to Fig. 1. The surface-acoustic-wave apparatus according to the present embodiment has, as shown in Fig. 1, a longitudinally-coupled-resonator-type surface-acoustic-wave filter 101 in which three IDTs are formed on a piezoelectric substrate 501 in the direction in which surface acoustic waves propagate. An IDT 103 disposed at the center among the three IDTs of the longitudinally-coupled-resonator-type surface-acoustic-wave filter 101 is divided into two parts substantially symmetrically in the propagation direction of the surface acoustic waves and the two parts are connected to balanced signal terminals 108 and 109, respectively. The left and right IDTs 102 and 104 of which the polarities are inverted to each other are connected to an unbalanced signal terminal 107 to provide a balanced-to-unbalanced conversion function. The surface-acoustic-wave apparatus is characterized in that a reactance component 120 formed on the piezoelectric substrate, formed on a package, or externally connected to the package is connected to either of the balanced signal terminals 108 and 109.

With the above-described structure, the surface-acoustic-wave apparatus has the balanced-to-unbalanced conversion function, and the impedance of the balanced signal terminals is about four times as high as that of the unbalanced signal terminal. In addition, the balance degrees thereof are improved by the reactance component 120.

### (First embodiment)

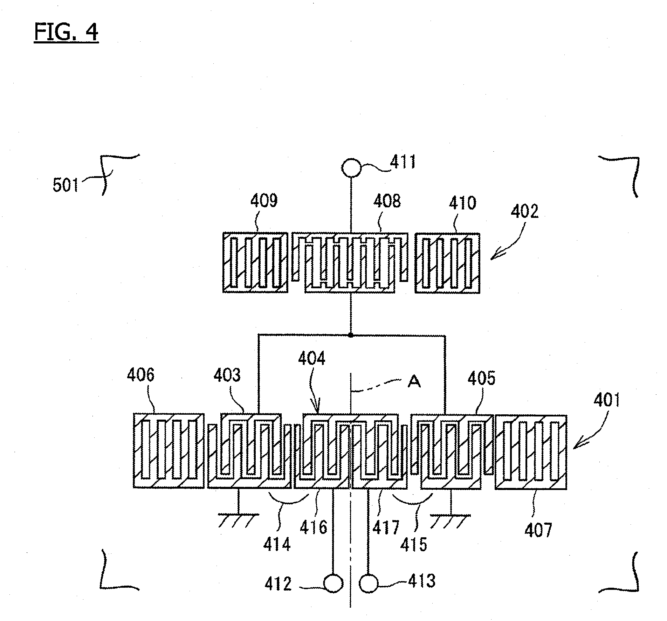

The structure of a first embodiment according to the present invention will be described below by referring to Fig. 4 to Fig. 7. In the following embodiments, a DCS receiving filter will be taken as an example. An electrode structure in the first embodiment will be described first by referring to Fig. 4. In the first embodiment, a longitudinally-coupled-resonator-type surface-acoustic-wave filter 401 and a surface-acoustic-wave resonator 402 connected in series to the longitudinally-coupled-resonator-type surface-acoustic-wave filter 401 are formed by aluminum (Al) electrodes on a piezoelectric substrate 501 made from 40 ±5-degree Y-cut X-propagation LiTaO₃.

In the longitudinally-coupled-resonator-type surface-acoustic-wave filter 401, IDTs 403 and 405 are formed so as to sandwich an IDT 404 from both sides in the direction in which surface acoustic waves propagate, and reflectors 406 and 407 are formed at outsides thereof.

The IDT 403 has two interdigital electrodes each of which is formed of a strip-shaped base end section (bus bar) and a plurality of parallel electrode fingers extending from one side of the base end section, perpendicular to the base end section. The interdigital electrodes are engaged with each other between their electrode fingers such that the sides of electrode fingers of the interdigital electrodes face each other.

The signal conversion characteristics and the pass band of the IDT 403 can be specified by setting the length and width of each electrode finger, the distance between adjacent electrode fingers, and an overlap width indicating the length of facing-to-each-other portions obtained when the interdigital electrodes are engaged. The other IDTs have the same basic structure as the IDT 403. The reflectors have a function for reflecting propagating surface acoustic waves in the directions reverse to those in which the waves have propagated.

In the above structure, as understood from Fig. 4, the pitches of several electrode fingers (portions 414 and 415 in Fig. 4) in vicinities of the boundary between the IDT 403 and the IDT 404 and the boundary between the IDT 404 and the IDT 405 are made smaller than that of the other electrode fingers of the IDTs.

One interdigital electrode of the IDT 404, disposed at the center, is divided into sub interdigital electrodes 416 and 417 in the propagation direction of surface acoustic waves, and the sub interdigital electrodes 416 and 417 are connected to balanced signal terminals 412 and 413, respectively. In the first embodiment, the other interdigital electrode of the IDT 404, facing the sub interdigital electrodes 416 and 417, is a floating electrode. It may be a grounded electrode. The IDT 405 has a structure that is phase inverted compared to that of the IDT 403. With this, the above structure has a balanced-to-unbalanced conversion function.

In the surface-acoustic-wave resonator 402, reflectors 409 and 410 are formed so as to sandwich an IDT 408. One interdigital electrode of the IDT 408 is connected to an unbalanced signal terminal 411, and the other interdigital electrode of the IDT 408 is connected to the IDT 403 and the IDT 405.

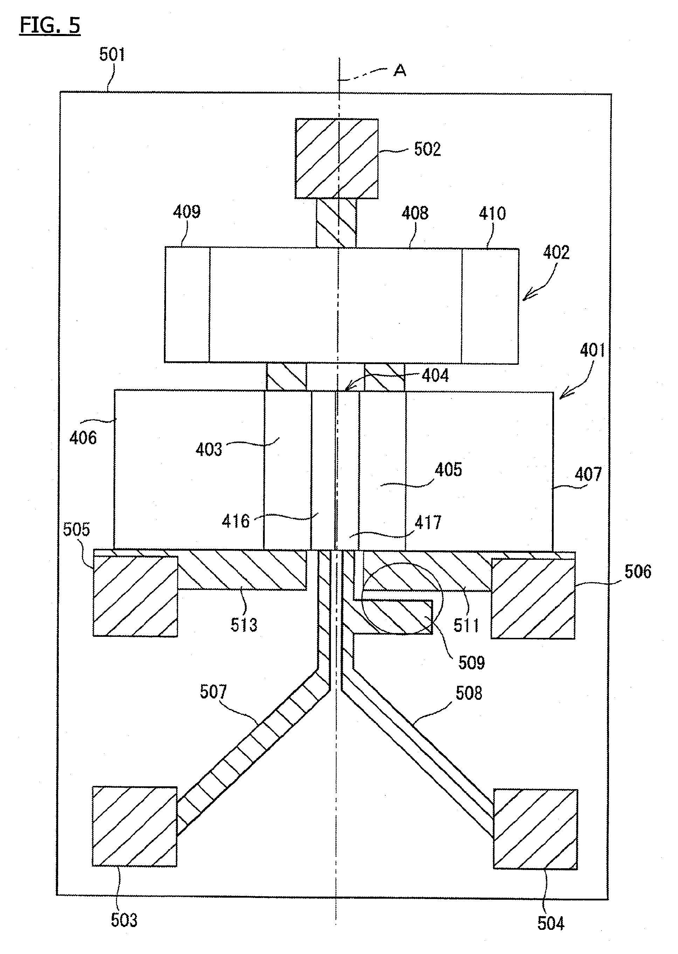

Fig. 5 shows an example of an actual layout on the piezoelectric substrate 501 according to the first embodiment. In Fig. 5, the same numbers as those used in Fig. 4 are assigned to portions corresponding to those shown in Fig. 4. In the layout, electrode pads 502 to 506 are provided to be electrically connected to a package. The electrode pad 502 corresponds to the unbalanced signal terminal 411, the electrode pads 503 and 504 correspond to the balanced signal terminals 412 and 413, respectively, and the electrode pads 505 and 506 are grounded terminals. Each IDT is shown in a simplified manner.

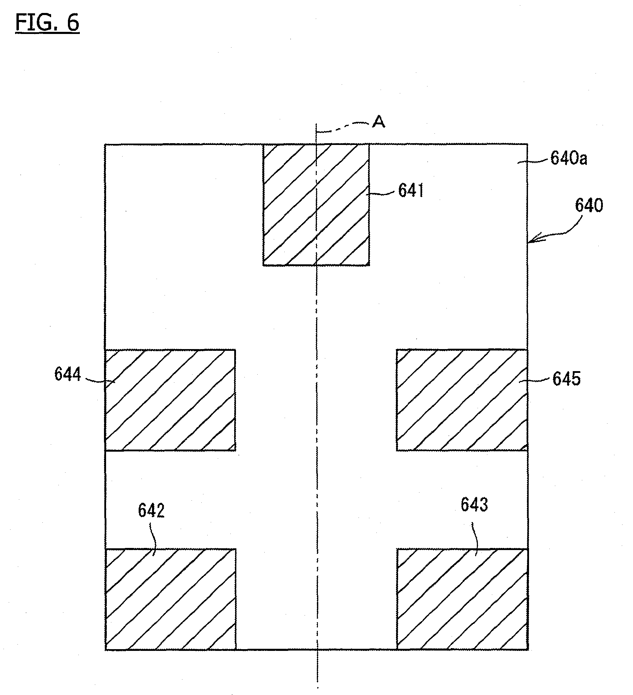

Fig. 6 shows (in a see-through view viewed from the upper-surface side of a surface-acoustic-wave apparatus (device)) electrode terminals 641 to 645 at the rear surface (rectangle-shaped) of an almost-rectangular-parallelepiped package 640 in which the structure according to the first embodiment is accommodated. The electrode terminal 641 is disposed almost at the center of one end section in the longitudinal direction of the rear surface 640a. The electrode terminals 642 and 643 are disposed at both comer sections of the other end section in the longitudinal direction of the rear surface 640a. The electrode terminals 644 and 645 are disposed almost at the centers of both side sections in the longitudinal direction of the rear surface 640a.

The electrode terminal 641 is the unbalanced signal terminal connected to the electrode pad 502, the electrode terminals 642 and 643 are the balanced signal terminals connected to the electrode pads 503 and 504, respectively, the electrode terminals 644 and 645 are the grounded terminals connected to the electrode terminals 505 and 506, respectively.

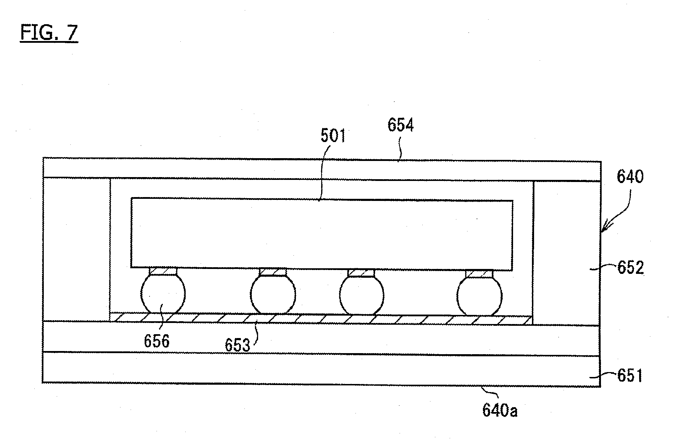

The surface-acoustic-wave apparatus according to the first embodiment is made by a face-down method as shown in Fig. 7, where the electrode surface of the piezoelectric substrate 501 and the die-attach surface 653 of the package 640 are electrically connected by bumps 656.

The package 640 has a rectangular-plate-shaped bottom plate 651, side wall sections 652 adjacent to each other and standing at the sides of the bottom plate 651, and a cap 654 for covering and contacting the upper ends of the side wall sections 652 to seal the inside of the package 640.

A feature of the first embodiment, seen in Fig.5, is that strip-shaped wiring 508 which connects the sub interdigital electrode 417 and the electrode pad 504 has a larger capacitance to the ground, corresponding to a reactance component 120 shown in Fig. 1, than strip-shaped wiring 507 which connects the sub interdigital electrode 416 and the electrode pad 503.

To make the capacitance to the ground larger, a protrusion 509 is additionally provided for the wiring 508 on the piezoelectric substrate 501 in the outside direction.

It is preferred that the protrusion 509 be provided for the wiring 508 at a position close to wiring 511 which connects the ground-side electrode pad 506 and the IDT 405.

It is also preferable that the protrusion 509 be provided almost in perpendicular to the wiring 508 in its longitudinal direction and almost in parallel to the wiring 511 in its longitudinal direction, and extend separately from the wiring 511.

With the protrusion 509, the capacitance to the ground of the balanced signal terminal 413, shown in Fig. 4, is larger than that of the balanced signal terminal 412, for example, by about 0.16 pF. Therefore, the wiring 508 and the wiring 507 are formed asymmetrically to each other.

The electrode fingers of the IDT 404 (the sub interdigital electrodes 416 and 417), adjacent to the IDTs 403 and 405 are signal electrodes. The electrode finger of the IDT 405, adjacent to the sub interdigital electrode 417 that is connected to the electrode pad 504 with the wiring which makes the capacitance to the ground larger, is also a signal electrode. The electrode finger of the IDT 403, adjacent to the sub interdigital electrode 416 that is connected to the electrode pad 503, is a ground electrode.

Further, in the first embodiment, except for the protrusion 509, which forms asymmetry, the structure, the layout on the piezoelectric substrate 501, and the package 640 are all symmetrical with respect to a virtual axis A which is perpendicular to the propagation direction of surface acoustic waves and at the center of the IDT 404 that is divided into the two electrodes, as shown in Fig. 4 to Fig. 6. With this, any unbalanced component is avoided except the different polarities of the electrode fingers of the IDT 403 and the IDT 405, adjacent to the IDT 404.

An example of detailed design parameters for the longitudinally-coupled-resonator-type surface-acoustic-wave filter 401 is shown below, where λI indicates the wavelength determined by the pitch of the electrode fingers for which the pitch has not been made smaller.
Overlap width: 78.9λI
Number of electrode fingers in IDTs (in the order of IDT 403, IDT 404, and IDT 405): 19 (3), (3) 26 (3), (3) 19 (the numbers of electrode fingers for which the pitch has been made smaller are indicated in parentheses)
Number of electrode fingers in reflectors: 200
Duty ratio: 0.67 (for both IDTs and reflectors)
Electrode film thickness: 0.095λ**I**

An example of detailed design parameters for the surface-acoustic-wave resonator 402 is shown below.
Overlap width: 46.5λ**I**
Number of electrode fingers in IDTs: 150
Number of electrode fingers in reflectors: 100
Duty ratio: 0.67
Electrode film thickness: 0.097λ**I**

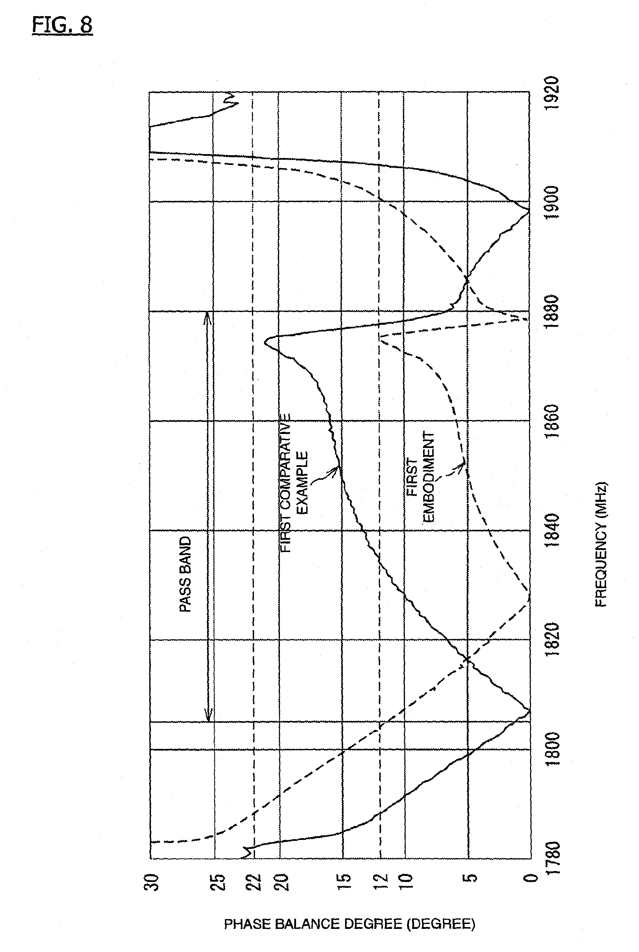

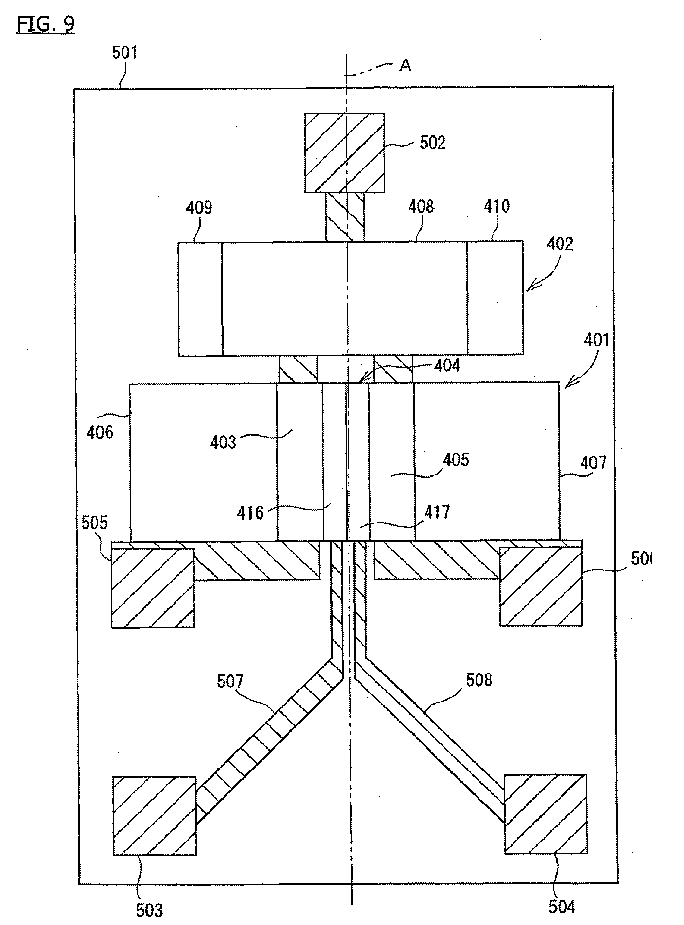

The operations and advantages related to the structure of the first embodiment will be described next. Fig. 8 shows the phase balance degree of the structure of the first embodiment. A first comparative example for comparison is the same as the first embodiment shown in Fig. 5 in structure, in design of the surface acoustic wave apparatus, in layout on the piezoelectric substrate 501, and in package mounting method except that, in the first comparative example, as shown in Fig. 9, the protrusion 509, which makes the capacitance to the ground larger, is not provided for the wiring 508 in the layout on the piezoelectric substrate 501 and the wiring 508 and the wiring 507 are set symmetrical with respect to the virtual axis A. Fig. 8 also shows the phase comparative degree of the first comparative example, which has no protrusion in the layout on the piezoelectric substrate 501.

The pass band of DCS receiving filters ranges from 1805 MHz to 1880 MHz. From Fig. 8, it is found that, whereas the first comparative example has a maximum shift of about 22 degrees in the phase balance degree in the pass band, the first embodiment has a maximum shift of about 12 degrees, which is improved by about 10 degrees. This is because the capacitance of the balanced signal terminal 413 to the ground is made larger, which compensates for a shift in phase between the balanced signal terminal 412 and the balanced signal terminal 413.

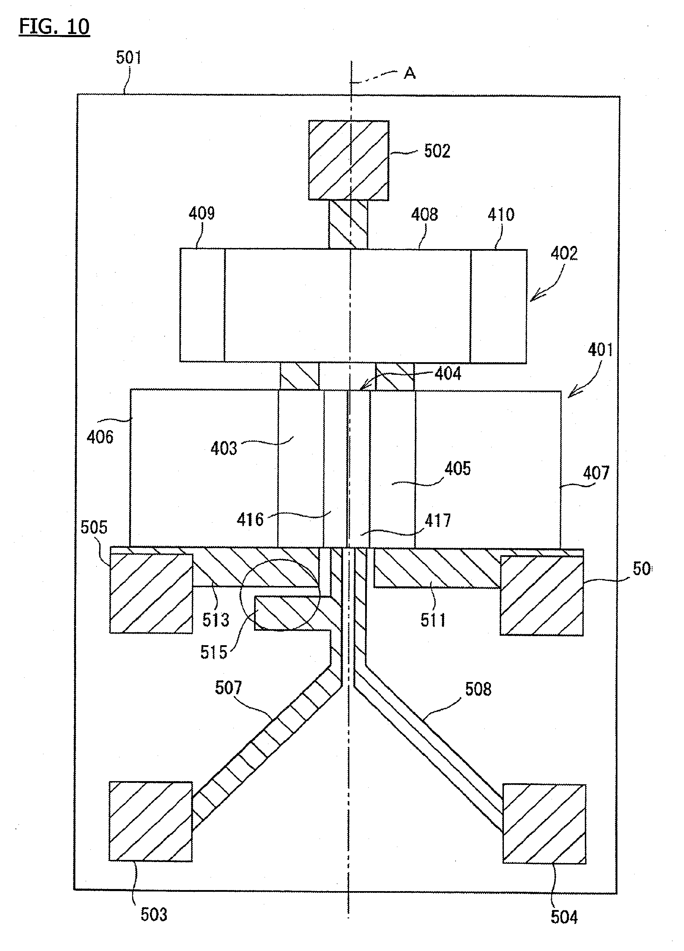

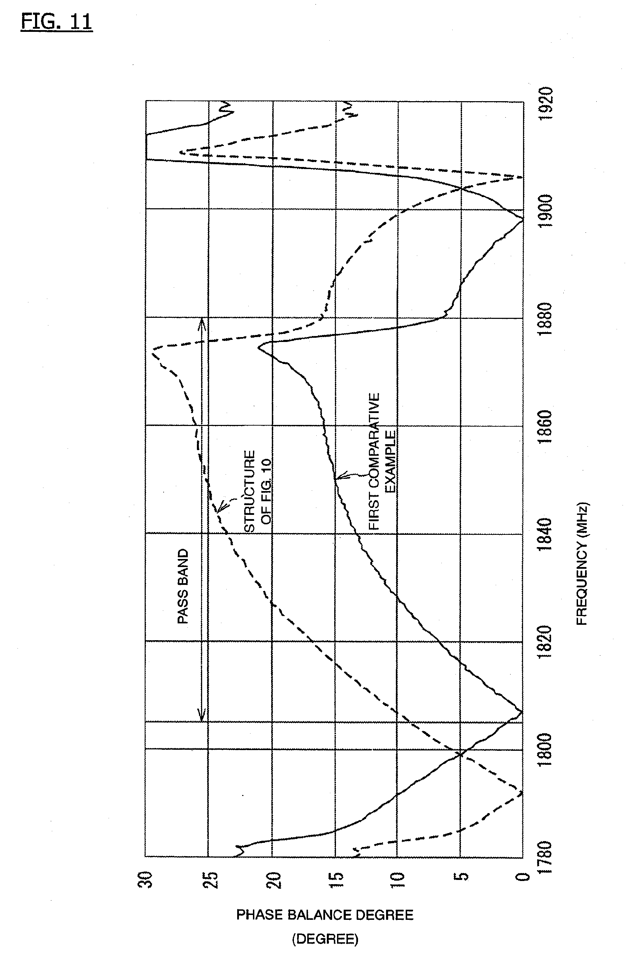

In the first embodiment, the protrusion 509, which makes the capacitance to the ground larger, is provided for the wiring 508. Conversely, a protrusion 515, which makes the capacitance to the ground larger, is provided for the wiring 507, as shown in Fig. 10, and thereby, the capacitance of the balanced signal terminal 412 to the ground is made larger by about 0.16 pF. A phase balance degree in this case is examined. Fig. 11 shows the phase balance degree obtained in the case shown in Fig. 10. Fig. 11 also shows the result of the first comparative example shown in Fig. 9, for comparison.

When the capacitance of the balanced signal terminal 412 to the ground is made larger, the phase balance degree becomes worse than that of the first comparative example. The capacitance of which balanced signal terminal to the ground is made larger needs to be determined by the arrangement of the electrode fingers of the IDTs 403 to 405, adjacent to each other, that is, whether there is a no-electric-field area, where signal electrodes are disposed adjacent to each other or where ground electrodes are disposed adjacent to each other.

In the first embodiment, the electrode fingers of the IDT 404, adjacent to the IDTs 403 and 405 are the sub interdigital electrodes 416 and 417, which are signal electrodes. The electrode finger adjacent to the IDT 404, of the IDT 405, which is adjacent to the sub interdigital electrode 417, that is connected to the wiring which makes the capacitance to the ground larger and connected to the electrode pad 504, is a signal electrode, and forms a no-electric-field area, or weak-electric-field area, together with the outermost electrode finger of the opposing sub interdigital electrode 417, which is a signal electrode. The electrode finger adjacent to the IDT 404, of the IDT 403, which is adjacent to the sub interdigital electrode 416, that is connected to the electrode pad 503, is a ground electrode, and forms an electric-field area which is larger in electric-field strength than the no-electric-field/weak-electric-field area in many cases, together with the outermost electrode finger of the opposing sub interdigital electrode 416, which is a signal electrode.

When electrode fingers are arranged in this way, if the protrusion 509, for example, is provided such that the capacitance of the balanced signal terminal 413 to the ground, connected to the sub interdigital electrode 417 having a no-electric-field area in a vicinity of its outermost electrode finger (or in contact with the outermost electrode finger), is relatively larger than that of the balanced signal terminal 412 connected to the sub interdigital electrode 416, as shown in the first embodiment, the phase balance degree is improved.

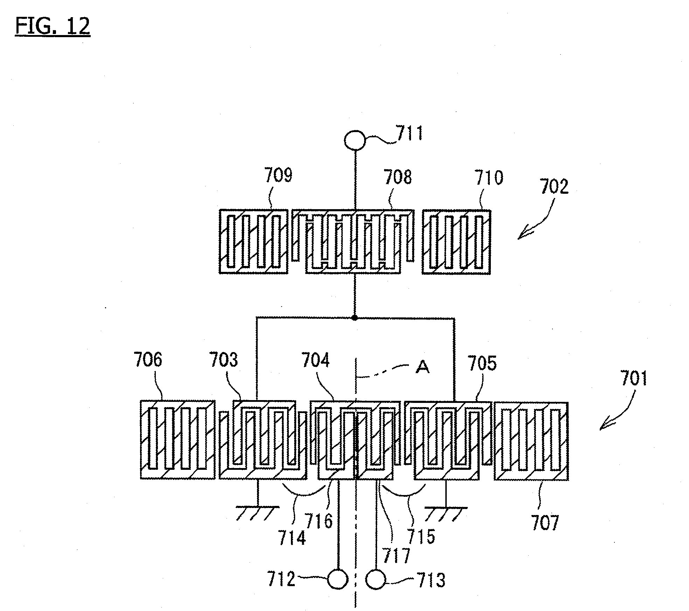

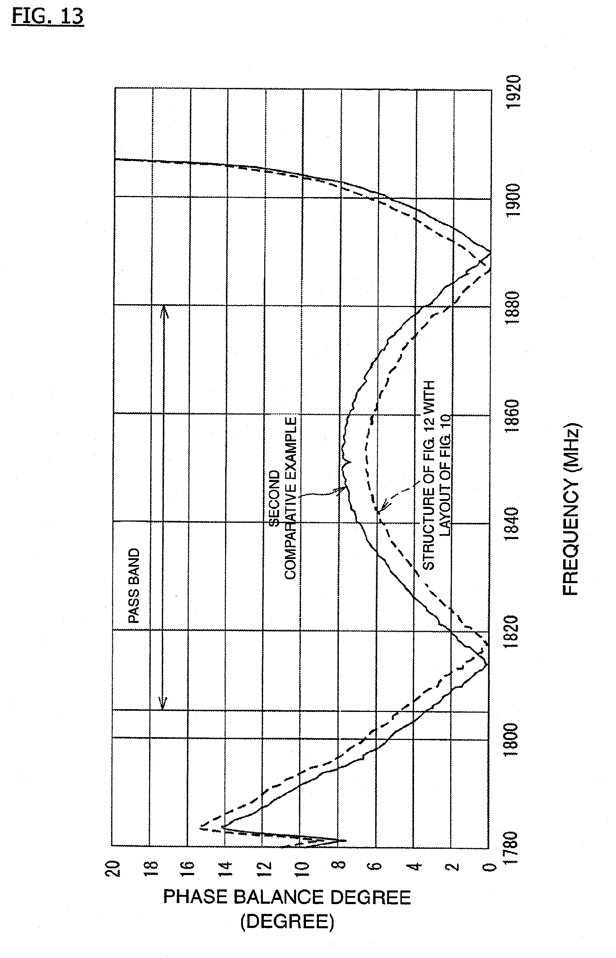

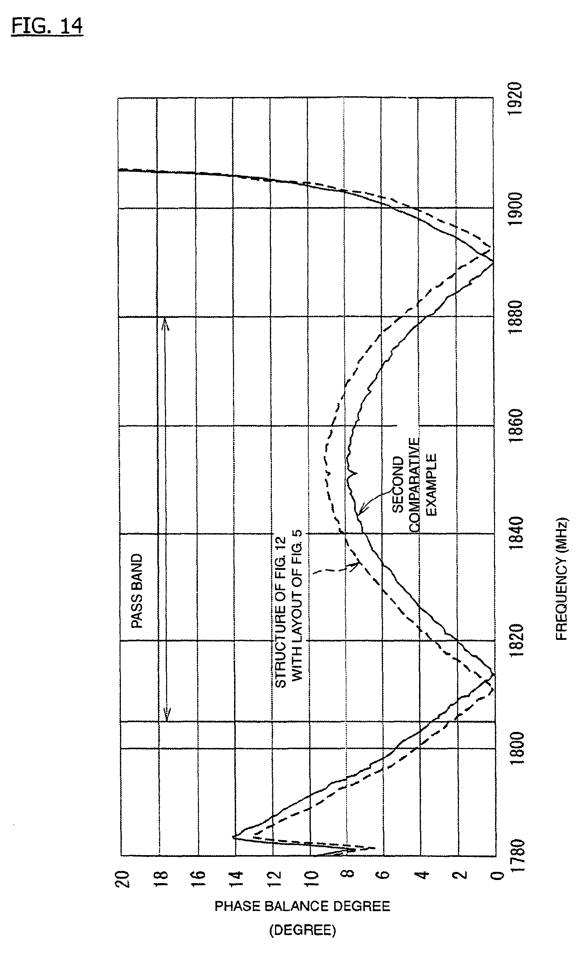

A case in which the electrode fingers of an IDT 704, adjacent to the IDTs 703 and 705 are neutral-point electrodes (either floating electrodes or ground electrodes can be used) as shown in Fig. 12 will be examined next. Fig. 13 shows the phase balance degree obtained at the electrode structure shown in Fig. 12 with the layout on the piezoelectric substrate 501 being set to that shown in Fig. 10 (a modification of the first embodiment). Fig. 14 shows the phase balance degree obtained at the electrode structure shown in Fig. 12 with the layout on the piezoelectric substrate 501 being set to that shown in Fig. 5 (third comparative example). Fig. 13 and Fig. 14 also show the phase balance degree obtained at the electrode structure shown in Fig. 12 with the layout on the piezoelectric substrate 501 being set to that (without a protrusion) shown in Fig. 9 as a second comparative example. Fig. 13 and Fig. 14 show the results obtained when the protrusions 515 and 509 are adjusted so as to correspond to a capacitance to the ground of about 0.02 pF.

It is understood that the phase balance degree is improved when the capacitance to the ground, of the balanced signal terminal 712, connected to the sub interdigital electrode 716, is made relatively larger than of the balanced signal terminal 713, connected to the sub interdigital electrode 717, as shown in the layout of Fig. 10 if electrode fingers are arranged as shown in Fig. 12.

Cases in which a delay line and an inductance component are added in series to a balanced signal terminal in an unbalanced manner at the electrode structure shown in Fig. 12 will be next examined.

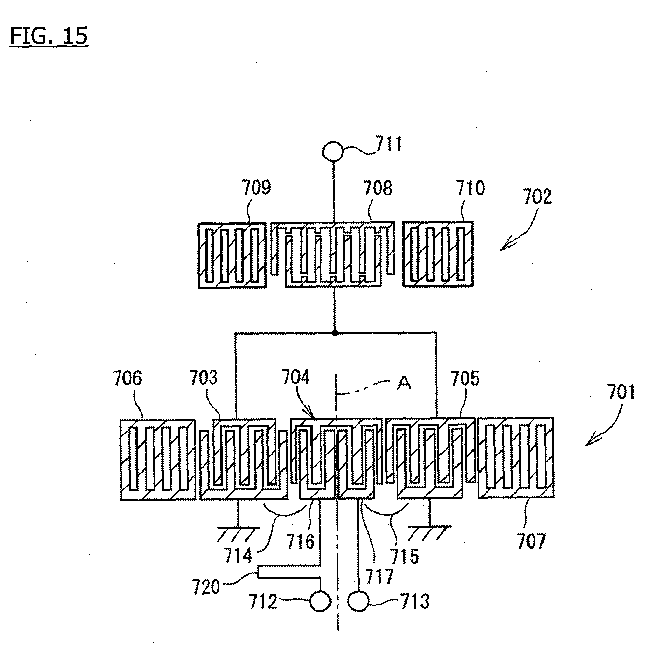

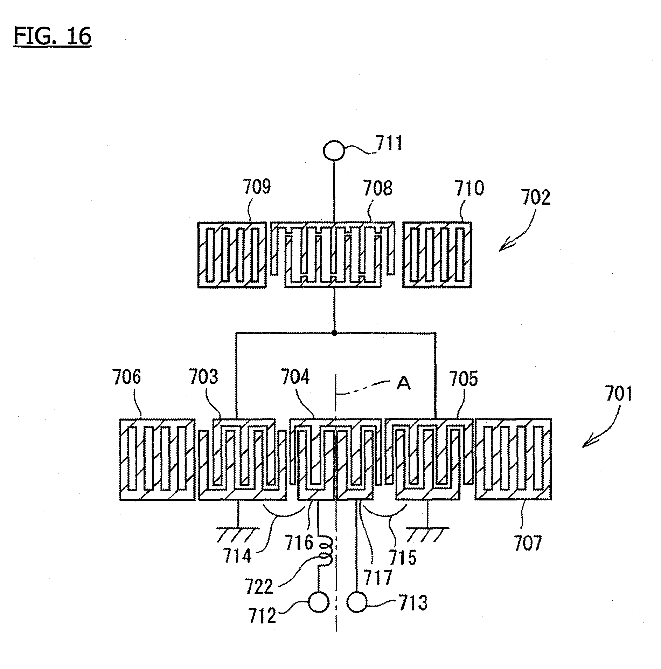

Fig. 15 shows a structure (another modification of the first embodiment) in which a delay line 720 serving as the reactance component 120 shown in Fig. 1 is added to the balanced signal terminal 712, connected to the sub interdigital electrode 716. Fig. 16 shows a structure (still another modification of the first embodiment) in which an inductance component 722 serving as the reactance component 120 shown in Fig. 1 is added.

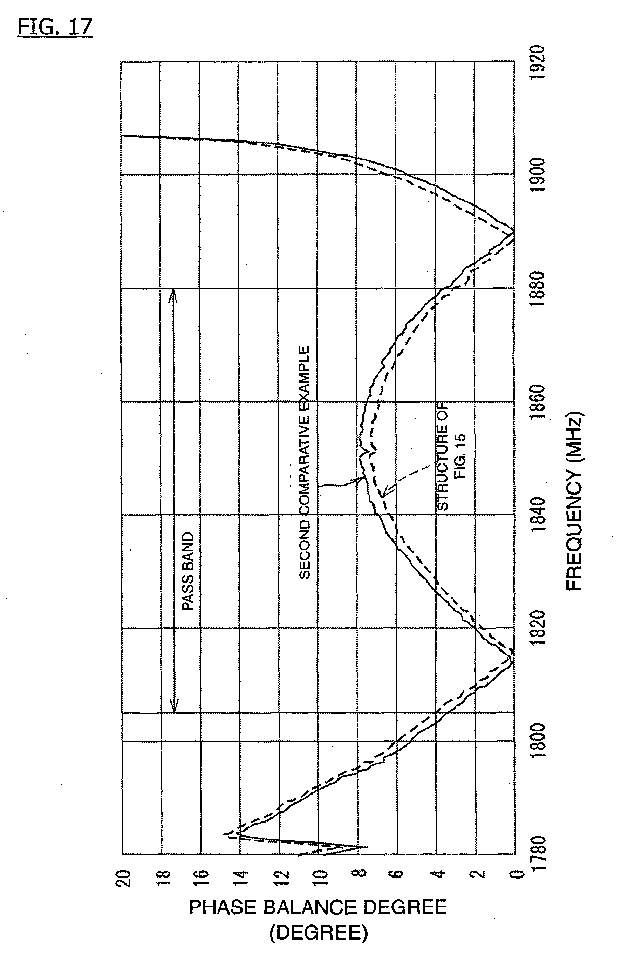

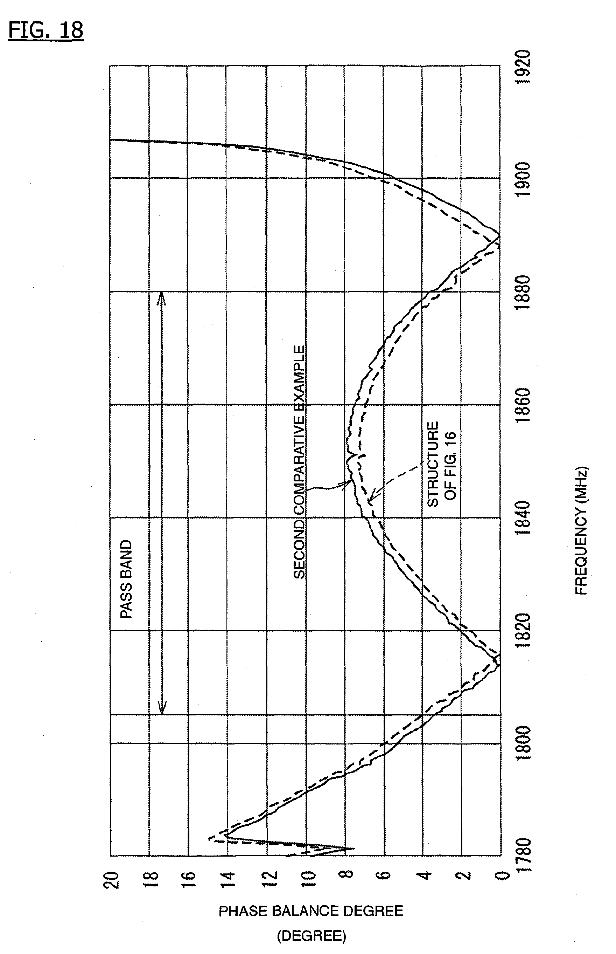

Fig. 17 and Fig. 18 show the phase balance degree obtained at the structures shown in Fig. 15 and Fig. 16, respectively. Fig. 17 and Fig. 18 also show the phase balance degree obtained at the electrode structure shown in Fig. 12 with the layout of Fig. 9, where neither a delay line nor an inductance component is added, as the second comparative example.

Specific methods for forming the delay line 720 and the inductance component 722 are omitted, but can include a method in which the delay line is formed of long wiring on the piezoelectric substrate or in the package, and the inductance component is formed of a microstripline.

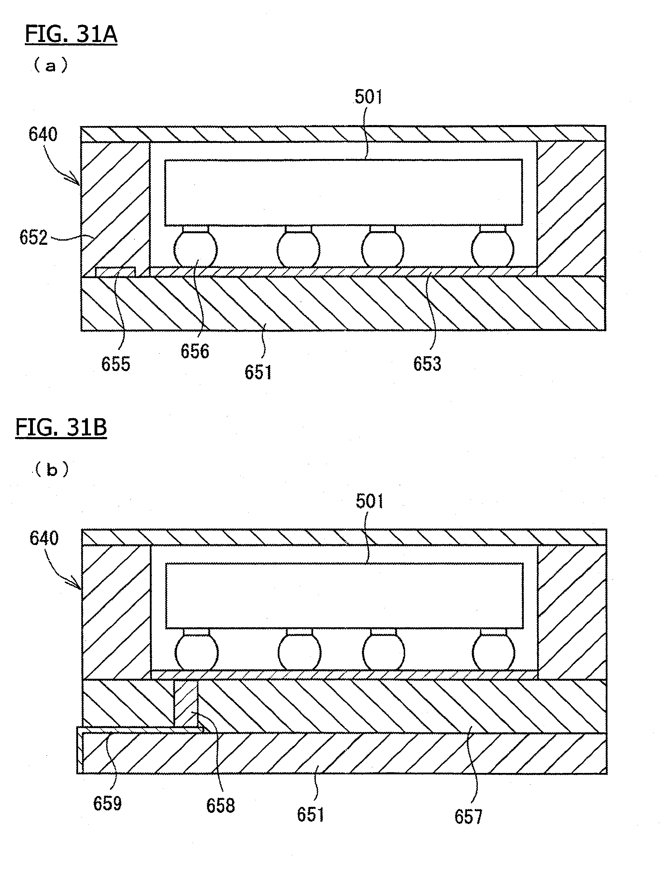

If possible, they may be provided at the outside of the package and externally connected, as shown in Fig. 31A and Fig. 31B. In Fig. 31A, a circuit 655 serving as the delay line and the inductance component (reactance component) is provided at the boundary of the bottom plate 651 and a side wall section 652 of the package 640. In Fig. 31B, a lamination plate 657 is provided on the bottom plate 651, a via hole 658 is provided for the lamination plate 657 in its thickness direction, and a circuit 659 serving as the delay line and the inductance component is connected through the via hole 658 and is provided between the bottom plate 651 and the lamination plate 657 of the package 640.

It is understood from Fig. 17 and Fig. 18 that the phase balance degree obtained when either of the delay line 720 and the inductance component 722 is inserted is better than that obtained in the second comparative example. In the electrode structure shown in Fig. 4, if the delay line 720 or the inductance component 722 is used it needs to be added to the balanced signal terminal 413.

As described above, in the first embodiment, in the surface-acoustic-wave apparatus having the longitudinally-coupled-resonator-type surface-acoustic-wave filter in which the three IDTs are formed in the directions in which surface acoustic waves propagate, on the piezoelectric substrate, where the IDT disposed at the center among the three IDTs is divided into two parts in the propagation direction of the surface acoustic waves and the polarities of the left and right IDTs are inverted to each other to provide a balanced-to-unbalanced conversion function, when the reactance component formed of at least one of the capacitance to the ground, the inductance component connected in series, and the delay line connected in series is made asymmetrical between the two balanced signal terminals, the phase balance degree of the surface-acoustic-wave apparatus is improved.

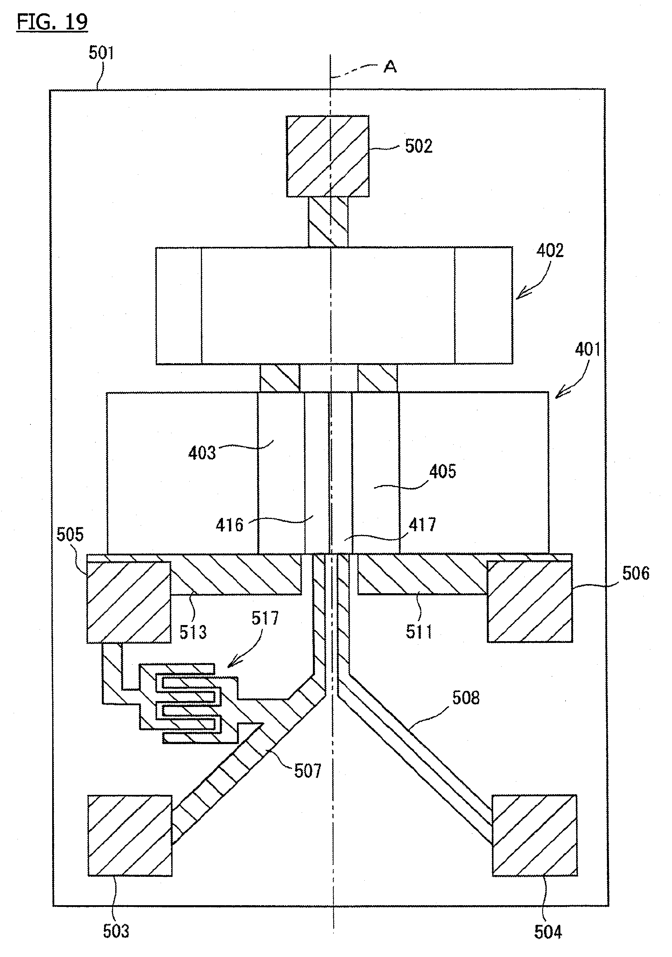

In the first embodiment, as shown in Fig. 5, a signal electrode is disposed close to a ground electrode on the piezoelectric substrate 501 to make the capacitance to the ground larger. Instead, a capacitor 517 may be formed by interdigital electrodes as shown in Fig. 19. Alternatively, wiring may be adjusted in the package 640.

In the first embodiment, the layout on the piezoelectric substrate 501 and the package 640 are made in the same way for the balanced signal terminals in order to avoid an extraneous unbalanced component, except that the capacitor to the ground, the inductance component, or the delay line is added asymmetrically. To this end, there are five electrode terminals 641 to 645 at the rear surface 640a of the package 640 (see Fig. 6). The present invention is not limited to such a package. Any packages may be used if they can be symmetrical with respect to a virtual axis A perpendicular to the propagation directions of surface acoustic waves and dividing a center IDT into two parts.

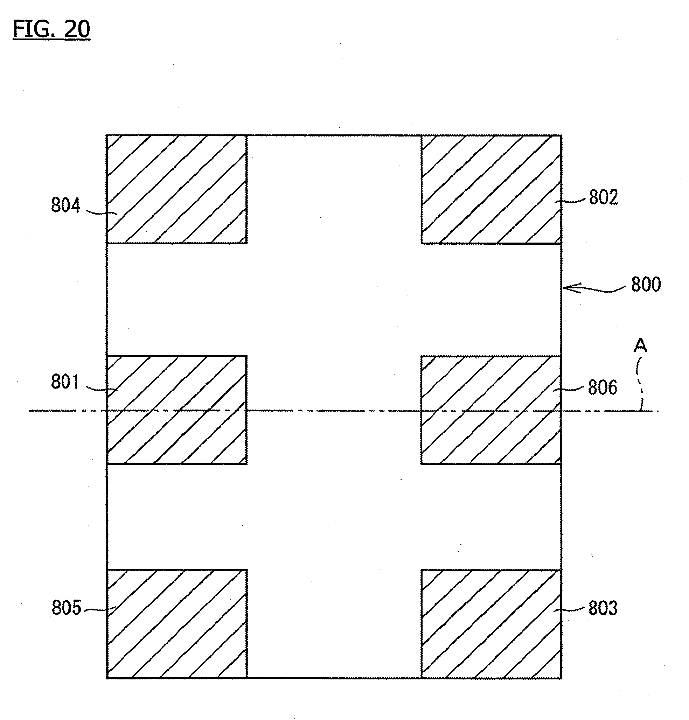

For example, a package 800 having six electrode terminals 801 to 806 as shown in Fig. 20 is symmetrical with respect to a virtual axis A when the electrode terminal 801 is used as an unbalanced signal terminal, the electrode terminals 802 and 803 are used as balanced signal terminals, the electrode terminals 804 to 806 are used as ground terminals.

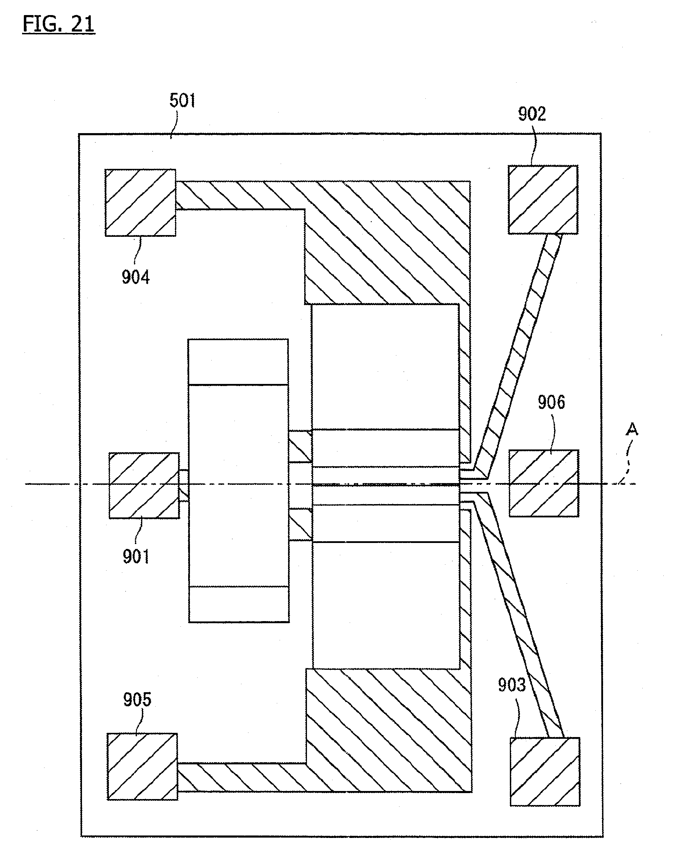

In this case, a layout on the piezoelectric substrate 501 is made such that the propagation direction of surface acoustic waves is parallel to the longitudinal direction of the piezoelectric substrate 501. When an electric pad 901 (see Fig.21) on the piezoelectric substrate 501 is connected to the electrode terminal 801, an electrode pad 902 is connected to the electrode terminal 802, an electrode pad 903 is connected to the electrode terminal 803, and electrode pads 904 to 906 are connected to the electrode terminals 804 to 806 serving as ground terminals, the layout on the piezoelectric substrate 501 is also made symmetrical with respect to the virtual axis A easily.

In the first embodiment, the package and the piezoelectric substrate are electrically connected by the face-down method to make the surface-acoustic-wave apparatus, as shown in Fig. 7. A wire bonding method may be used instead.

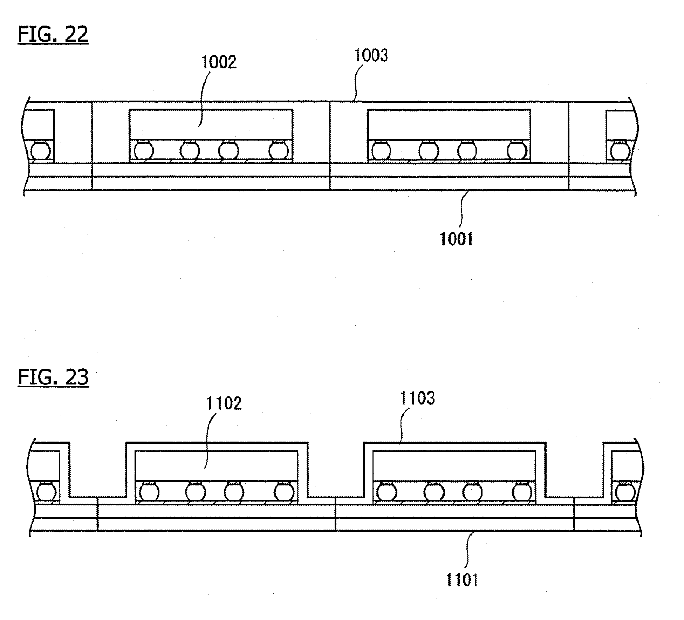

The structure used to make the surface-acoustic-wave apparatus by the face-down method is not limited to that shown in Fig. 7. For example, as shown in Fig. 22, the structure may be formed such that piezoelectric substrates 1002 are connected to an assembly board 1001 by a flip-chip method, are then covered and sealed by resin 1003, and are cut into each package by dicing. Alternatively, the structure may be formed as shown in Fig. 23 such that piezoelectric substrates 1002 are connected to an assembly board 1001 by a flip-chip method, are then covered and sealed by a sheet-shaped resin member 1003, and are cut into each package by dicing.

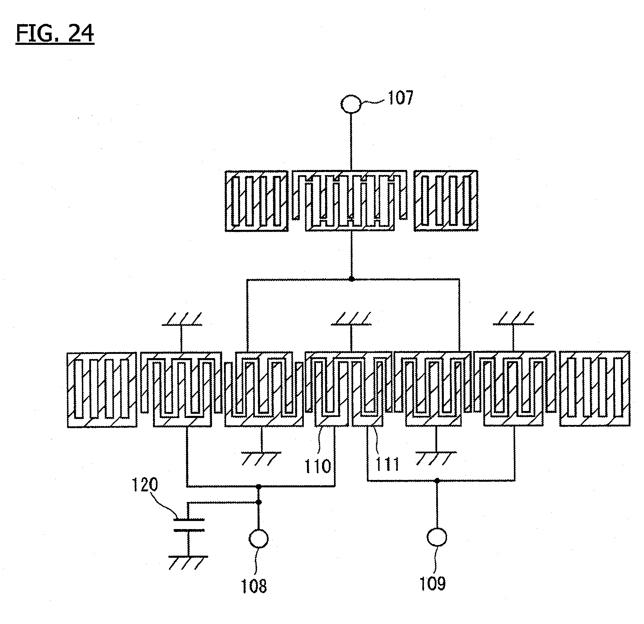

In the first embodiment, a surface-acoustic-wave resonator is connected in series to a longitudinally-coupled-resonator-type surface-acoustic-wave filter having the three IDTs. It is obvious that the same advantages are obtained when the surface-acoustic-wave resonator is not connected, or further when the surface-acoustic-wave resonator is connected in parallel. Alternatively, as shown in Fig. 24, IDTs may be provided at both sides of the three IDTs to form a longitudinally-coupled-resonator-type surface-acoustic-wave filter having five IDTs or a greater odd number of IDTs.

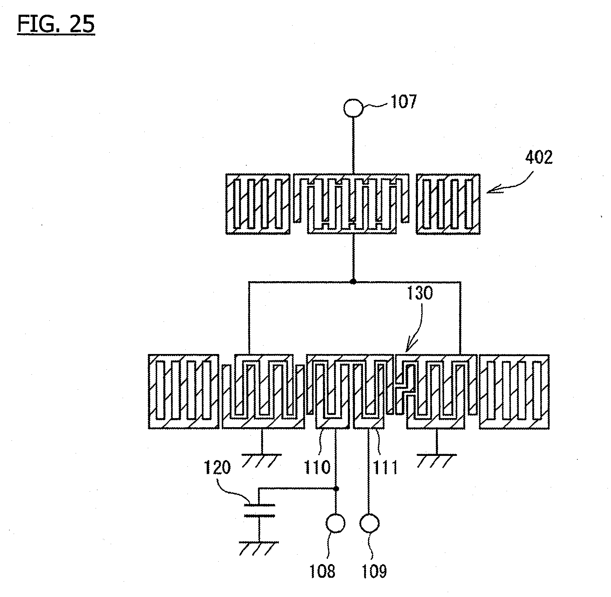

Furthermore, even when a weight is applied to an electrode finger 130 close to the boundary of adjacent IDTs, as shown in Fig. 25, the same advantages as in the present invention are obtained. The balance degrees are further improved in the structure shown in Fig. 25. A thinning-out weight, an overlap-width weight, or a duty ratio weight may be applied.

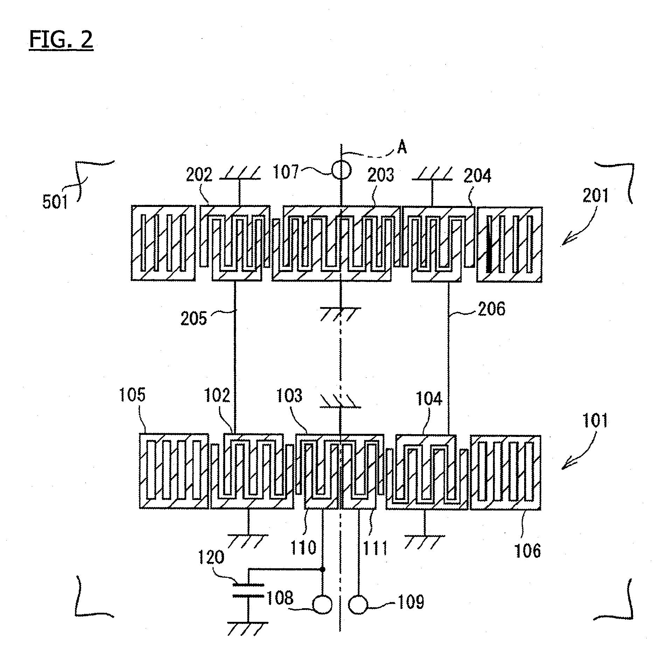

In the present invention, as shown in Fig. 2, a longitudinally-coupled-resonator-type surface-acoustic-wave filter 101 may be connected in cascade to another longitudinally-coupled-resonator-type surface-acoustic-wave filter 201. In this case, it is preferred that an IDT 203 positioned at the center of the longitudinally-coupled-resonator-type surface-acoustic-wave filter 201 has an even number of electrode fingers.

It is also preferred that the directions of IDTs 102, 104, 202, and 204 be adjusted such that signals transferring through signal lines 205 and 206 which connect the longitudinally-coupled-resonator-type surface-acoustic-wave filter 101 and the longitudinally-coupled-resonator-type surface-acoustic-wave filter 201 have an almost-180-degree phase difference. With this structure, a surface-acoustic-wave apparatus having further improved balance degrees is obtained.

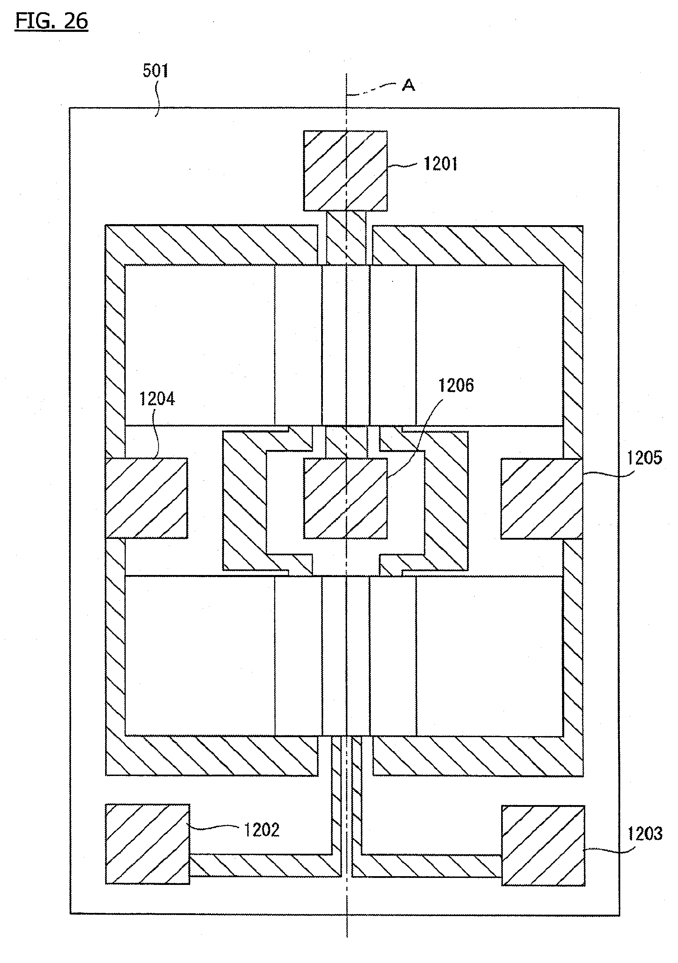

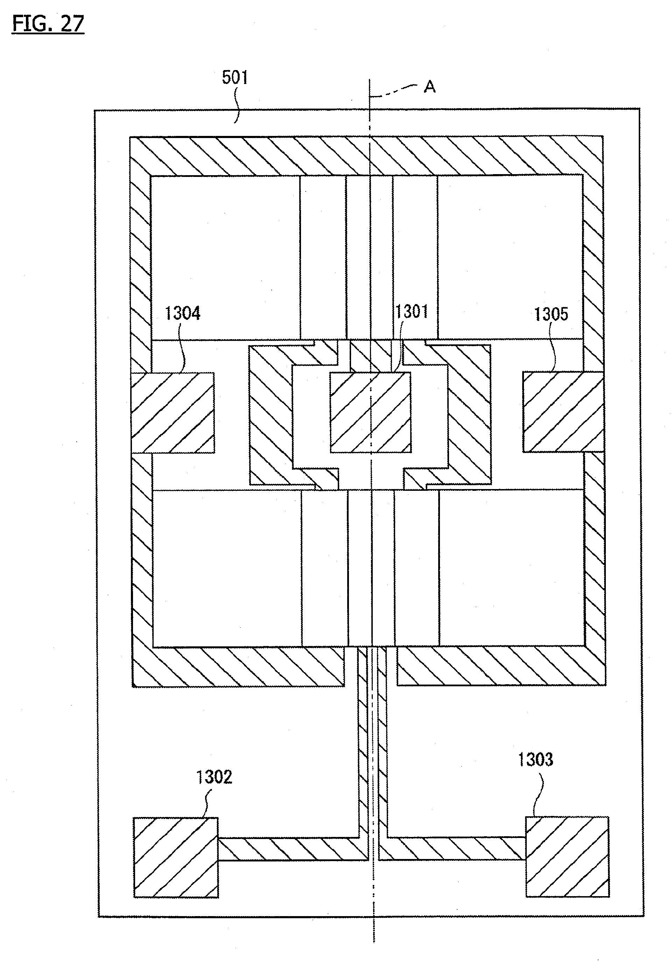

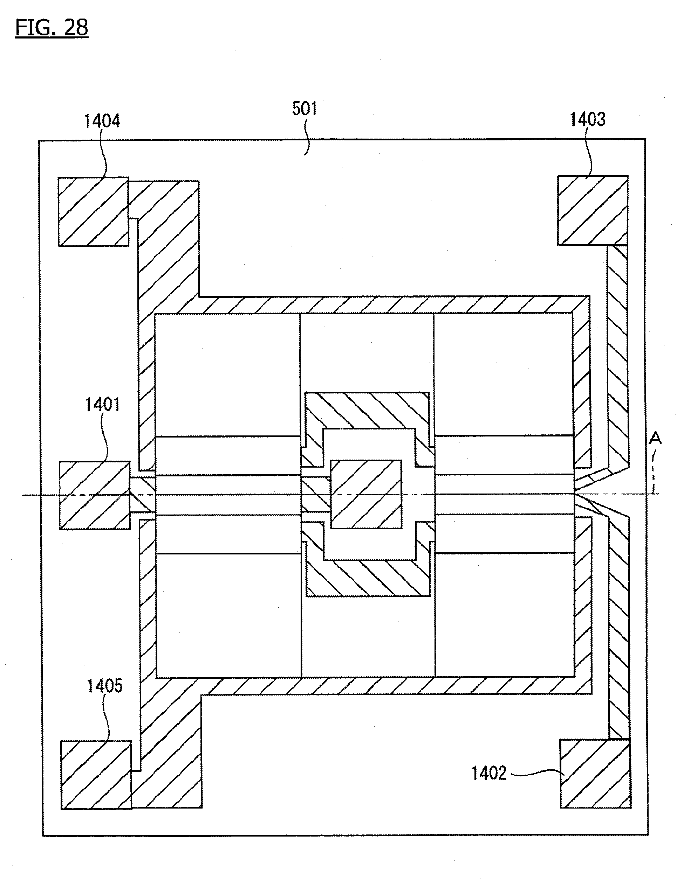

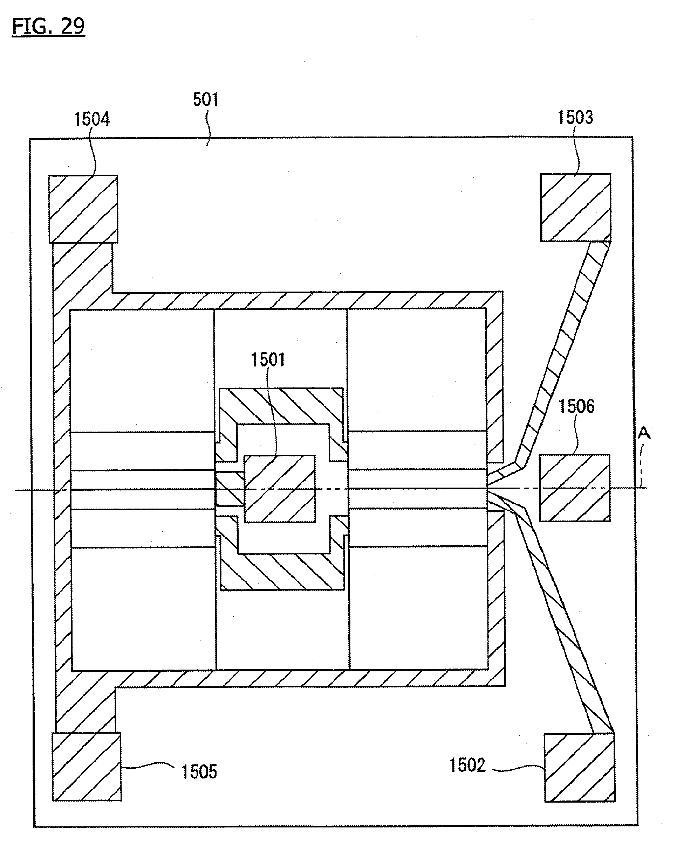

Fig. 26 and Fig. 27 show example layouts on the piezoelectric substrate 501, used with the electrode structure shown in Fig. 2 when the package having five electrode terminals shown in Fig. 6 is used. Fig. 28 and Fig. 29 show example layouts on the piezoelectric substrate 501, used with the electrode structure shown in Fig. 2 when the package having six electrode terminals shown in Fig. 20 is used.

Electrode pads 1201, 1301, 1401, and 1502 are connected to unbalanced signal terminals, electrode pads 1202, 1203, 1302, 1303, 1402, 1403, 1502, and 1503 are connected to balanced signal terminals, and the remaining electrode pads are connected to ground terminals.

In the first embodiment, a 40 ±5-degree Y-cut X-propagation LiTaO₃ substrate is used as the piezoelectric substrate 501. As understood from the principle, from which the advantages are obtained, the present invention is not limited to this piezoelectric substrate 501. Even with piezoelectric substrates, such as 64 to 72-degree Y-cut X-propagation LiNbO₃ substrates and a 41-degree Y-cut X-propagation LiNbO₃ substrate, the same advantages are obtained.

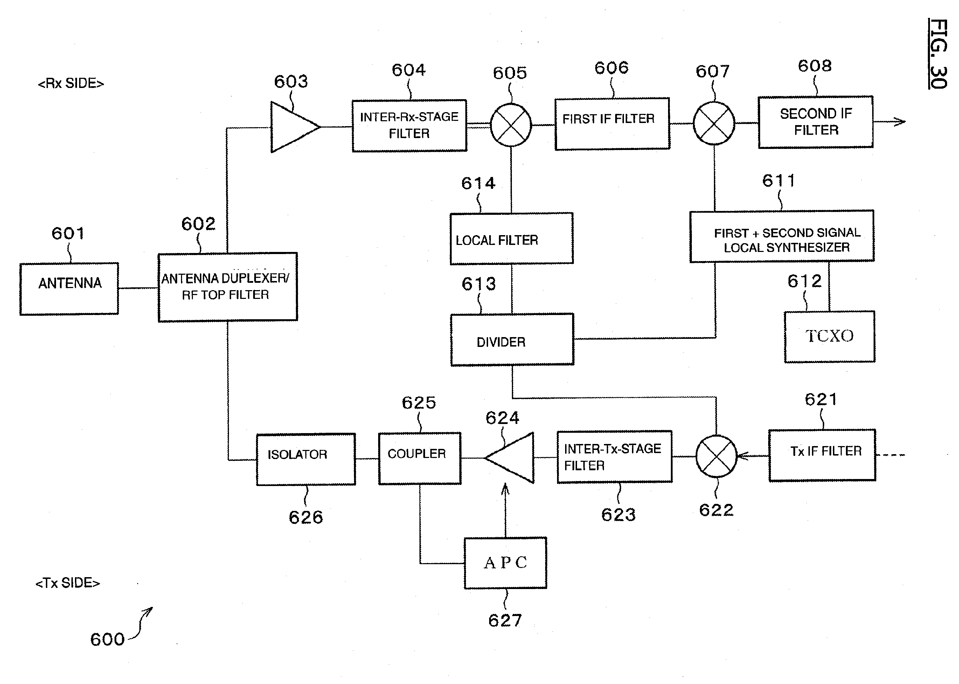

A communications apparatus in which a surface-acoustic-wave apparatus according to the present invention, the apparatus being one of the first embodiment and modifications of the first embodiment, according to the present invention, or a combination thereof, is used will be described next by referring to Fig. 30.

As shown in Fig. 30, the communications apparatus 600 includes in a receiver side (Rx side) for receiving, an antenna 601, an antenna duplexer/RF top filter 602, an amplifier 603, an inter-Rx-stage filter 604, a mixer 605, a first IF filter 606, a mixer 607, a second IF filter 608, a first + second signal local synthesizer 611, a temperature compensated crystal oscillator (TCXO) 612, a divider 613, and a local filter 614. It is preferred that balanced signals be transmitted from the inter-Rx-stage filter 604 to the mixer 605 in order to maintain balance, as indicated by a doubled line in Fig. 30.

The communications apparatus 600 also includes in a transmitter side (Tx side) for transmission, the antenna 601 and the antenna duplexer/RF top filter 602, both of which are shared, along with a Tx IF filter 621, a mixer 622, an inter-Tx-stage filter 623, an amplifier 624, a coupler 625, an isolator 626, and an automatic power control (APC) 627.

The surface-acoustic-wave apparatus according to the present embodiment and its modifications described above can be suitably used for any or all of the inter-Rx-stage filter 604, the first IF filter 606, the Tx IF filter 621, the inter-Tx-stage filter 623, and the antenna duplexer/RF top filter 602.

A surface-acoustic-wave apparatus according to the present embodiment has a balanced-to-unbalanced conversion function as well as a filter function, and also has excellent characteristics in which the amplitude characteristic and the phase characteristic between balanced signals are closer to the ideal characteristics. Therefore, a communications apparatus according to the present invention, having the above-described surface-acoustic-wave apparatuses combined can have a reduced number of components, a reduced size, and an improved transfer characteristic.

## Claims

1. A surface-acoustic-wave apparatus comprising a longitudinally-coupled-resonator-type surface-acoustic-wave filter (101) in which an odd number of three or more of interdigital transducers (102-104) are formed on a piezoelectric substrate (501) in the direction in which surface acoustic waves propagate, one interdigital electrode of an interdigital transducer (103) disposed at the center among the odd number of interdigital transducers is divided into two parts (110,111) along the propagation direction of the surface acoustic waves and the two parts (110,111) are connected to balanced signal terminals (108,109), respectively, and two interdigital transducers (102,104) adjacent to the interdigital transducer (103) disposed at the center have structures inverted to each other and are connected to an unbalanced signal terminal (107) to have a balanced-to-unbalanced conversion function,
wherein an outermost electrode finger of the interdigital transducer (103) disposed at the center is a floating electrode or a grounded electrode, and
wiring is formed asymmetrically such that a balanced signal terminal (108) closer to an interdigital transducer (102) of which an outermost electrode finger adjacent to the interdigital transducer (103) disposed at the center is grounded, of the two interdigital transducers (102,104) adjacent to the interdigital transducer (103) disposed at the center, has a relatively larger capacitance.

2. A surface-acoustic-wave apparatus according to claim 1, wherein the asymmetrical wiring comprises a reactance component (120) or a delay line (720) added to said balanced signal terminal (108) closer to an interdigital transducer (102) of which an outermost electrode finger adjacent to the interdigital transducer (103) disposed at the center is grounded, of the two interdigital transducers (102,104) adjacent to the interdigital transducer (103) disposed at the center.

3. A surface-acoustic-wave apparatus comprising a longitudinally-coupled-resonator-type surface-acoustic-wave filter (401) in which an odd number of three or more of interdigital transducers (403-405) are formed on a piezoelectric substrate (501) in the direction in which surface acoustic waves propagate, one interdigital electrode of an interdigital transducer (404) disposed at the center among the odd number of interdigital transducers is divided into two parts (416,417) along the propagation direction of the surface acoustic waves and the two parts (416,417) are connected to balanced signal terminals (412,413), respectively, and two interdigital transducers (403,405) adjacent to the interdigital transducer (404) disposed at the center have structures inverted to each other and are connected to an unbalanced signal terminal (411) to have a balanced-to-unbalanced conversion function,
wherein an outermost electrode finger of the interdigital transducer (404) disposed at the center is a signal electrode, and
wiring (507-509) is formed asymmetrically such that a balanced signal terminal (413) closer to an interdigital transducer (405) of which an outermost electrode finger adjacent to the interdigital transducer (404) disposed at the center is a signal electrode, of the two interdigital transducers (403,405) adjacent to the interdigital transducer (404) disposed at the center, has a relatively larger capacitance.

4. A surface-acoustic-wave apparatus according to claim 3, wherein the asymmetrical wiring comprises a reactance component (120) or a delay line (720) added to said balanced signal terminal (413) closer to an interdigital transducer (405) of which an outermost electrode finger adjacent to the interdigital transducer (404) disposed at the center is a signal electrode, of the two interdigital transducers (403,405) adjacent to the interdigital transducer (404) disposed at the center.

5. A surface-acoustic-wave apparatus according to Claim 1, 2, 3 or 4, wherein the piezoelectric substrate (501) is mounted on a package (640) by flip-chip bonding, and the asymmetrical wiring is formed on the package.

6. A surface-acoustic-wave apparatus according to any one of Claims 1 to 5, wherein the piezoelectric substrate (501) is mounted on a package (640) and the wiring on the piezoelectric substrate (501) and on the package (640) is formed substantially symmetrically with respect to a virtual axis (A) perpendicular to the propagation directions of the surface acoustic waves at the center of the interdigital transducer disposed at the center, except the asymmetrical wiring.

7. A surface-acoustic-wave apparatus according to Claim 2, wherein the reactance component (120) is a capacitance component, and is connected in parallel between the balanced signal terminal (108) and a ground potential.

8. A surface-acoustic-wave apparatus according to Claim 2, wherein the reactance component (120) is an inductance component, and is connected in series to the balanced signal terminal (108).

9. A surface-acoustic-wave apparatus according to any previous Claim, wherein a surface-acoustic-wave resonator (402) is added in series and/or in parallel to the surface-acoustic-wave filter.

10. A surface-acoustic-wave apparatus according to any previous Claim, wherein a plurality of the surface-acoustic-wave filters (101,201) are connected in cascade to each other.

11. A surface-acoustic-wave apparatus according to Claim 10, wherein the total number of the electrode fingers of the surface-acoustic-wave filters (101,201) connected in cascade is an even number.

12. A surface-acoustic-wave apparatus according to Claim 10 or 11, wherein interdigital transducers (202/204) positioned at both ends of each of the surface-acoustic-wave filters (101,201) connected in cascade to each other are connected to interdigital transducers (102/104) positioned at both ends of another, by signal lines (205/206), and the phases of signals passing through the signal lines are different by about 180 degrees.

13. A surface-acoustic-wave apparatus according to any previous Claim, wherein an electrode finger (130) of at least one interdigital transducer of adjacent interdigital transducers, close to the boundary of the interdigital transducers is weighted in the surface-acoustic-wave filter.

14. A surface-acoustic-wave apparatus according to Claim 13, wherein the weighting is performed by series weighting.

15. A surface-acoustic-wave apparatus according to any previous Claim, wherein the piezoelectric substrate (501) is mounted on a package (800) by flip-chip bonding, the package has six external terminals (801-6), one unbalanced signal terminal (801), two balanced signal terminals (802,803), and three ground terminals (804-6), and the six terminals are arranged substantially symmetrically with respect to a virtual axis (A) perpendicular to the propagation directions of the surface acoustic waves at the center of the interdigital transducer positioned at the center of the surface-acoustic-wave filter.

16. A surface-acoustic-wave apparatus according to any one of Claims 1 to 14, wherein the piezoelectric substrate (501) is mounted on a package (640) by flip-chip bonding, the package has five external terminals (641-5), one unbalanced signal terminal (641), two balanced signal terminals (642,643), and two ground terminals (644,645), and the five terminals are arranged substantially symmetrically with respect to a virtual axis (A) perpendicular to the propagation directions of the surface acoustic waves at the center of the interdigital transducer positioned at the center of the surface-acoustic-wave filter.

17. A communications apparatus comprising the surface-acoustic-wave apparatus according to any previous Claim.
